# EUROPEAN PATENT SPECIFICATION

(11) **EP 4 521 857 B1**
(45) Date of publication and mention of the grant of the patent: **22.07.2026**
(21) Application number: 24729715.3
(22) Date of filing: 27.05.2024
(51) Int. Cl.: G06F 1/16, H05K 1/02, H04M 1/02, H05K 1/14

(54) **ELECTRONIC DEVICE INCLUDING FLEXIBLE PRINTED CIRCUIT BOARD**
ELEKTRONISCHE VORRICHTUNG MIT FLEXIBLER LEITERPLATTE
DISPOSITIF ÉLECTRONIQUE COMPRENANT UNE CARTE DE CIRCUIT IMPRIMÉ SOUPLE

(30) Priority: 17.07.2023 KR 20230092291; 28.08.2023 KR 20230113062
(43) Date of publication of application: 12.03.2025
(73) Proprietor: Samsung Electronics Co., Ltd, Suwon-si, Gyeonggi-do 16677 (KR)
(72) Inventor: LEE, Youngsun, Gyeonggi-do 16677 (KR); KIM, Minki, Gyeonggi-do 16677 (KR); KIM, Byungjoon, Gyeonggi-do 16677 (KR); KIM, Youngjoon, Gyeonggi-do 16677 (KR); SEONG, Younghun, Gyeonggi-do 16677 (KR); YUN, Hyelim, Gyeonggi-do 16677 (KR)
(74) Representative: Nederlandsch Octrooibureau
(86) International application number: PCT/KR2024/007173
(87) International publication number: WO 2025/018566

(56) References cited:
- JP-A- 2010 109 152
- KR-A- 20180 032 375
- KR-A- 20200 021 172
- KR-A- 20200 048 238
- KR-A- 20220 012 028
- US-A1- 2015 250 049
- US-A1- 2022 346 224

## Description

### [Technical Field]

An embodiment(s) of the disclosure relates to an electronic device, e.g., an electronic device including a flexible printed circuit board.

### [Background Art]

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As electronic devices are highly integrated, and high-speed, high-volume wireless communication becomes commonplace, an electronic device, such as a mobile communication terminal, is being equipped with various functions. For example, an electronic device comes with the integrated functionality, including an entertainment function, such as playing video games, a multimedia function, such as replaying music/videos, a communication and security function for mobile banking, or a scheduling or e-wallet function.

Personal or portable communication devices such as smartphones spread, users' demand for portability and use convenience is on the rise. For example, a touchscreen display may not only serve as an output device of visual information but also provide a virtual keyboard that replaces a mechanical input device (e.g., a button input device). As such, portable communication devices or electronic devices may be made compact while delivering further enhanced applicability (e.g., a larger screen). Flexible displays, e.g., foldable or rollable displays, will come in commerce and electronic devices are expected to deliver better portability and use convenience. An electronic device including a flexible display may be carried in a folded or rolled state of a plurality of different structures (e.g., housings), and may provide a large screen in an unfolded state, thereby enhancing portability and ease of use.

The above-described information may be provided as related art for the purpose of helping understanding of the disclosure. No claim or determination is made as to whether any of the foregoing is applicable as prior art in relation to the disclosure.
US 2022/0346224 A1 relates to a flexible printed circuit board of an electronic device including a flexible display having a shape deformed by a hinge structure. The FPCB of an electronic device includes a plurality of bending portions and a plurality of non-bending portions. The plurality of bending portions is bent according to a deformation of a shape of the electronic device. The plurality of non-bending portions are positioned on a periphery of the plurality of bending portions. The plurality of bending portions and the plurality of non-bending portions are formed to have different thicknesses

### [Disclosure of Invention]

### [Solution To Problems]

According to an embodiment of the disclosure, an electronic device according to the claim 1 is provided.

### [Brief Description of Drawings]

The foregoing and other aspects, configurations, and/or advantages of an embodiment of the disclosure will be more apparent from the following detailed description taken in conjunction with the accompanying drawings.
FIG. 1 is a block diagram illustrating an electronic device in a network environment according to an embodiment of the disclosure;
FIG. 2 is a view illustrating an unfolded state of an electronic device according to an embodiment of the disclosure;
FIG. 3 is a view illustrating a folded state of an electronic device according to an embodiment of the disclosure;
FIG. 4 is an exploded perspective view illustrating an electronic device according to an embodiment of the disclosure;
FIG. 5 is a view illustrating a flexible printed circuit board of an electronic device according to an embodiment of the disclosure;
FIG. 6 is a view illustrating an unfolded state of an electronic device according to an embodiment of the disclosure;
FIG. 7 is a view illustrating a flexible printed circuit board of an electronic device according to an embodiment of the disclosure;
FIG. 8 is an enlarged view illustrating portion E1 of FIG. 7 in a flexible printed circuit board of an electronic device according to an embodiment of the disclosure;
FIG. 9 is a cross-sectional view taken along line A-A' of FIG. 8 in a flexible printed circuit board of an electronic device according to an embodiment of the disclosure;
FIG. 10 is an enlarged view illustrating portion E2 of FIG. 7 in a flexible printed circuit board of an electronic device according to an embodiment of the disclosure;
FIG. 11 is a view illustrating a flexible printed circuit board of an electronic device according to an embodiment of the disclosure;
FIG. 12 is a view illustrating a flexible printed circuit board of an electronic device according to an embodiment of the disclosure; and
FIG. 13 is a view illustrating a flexible printed circuit board of an electronic device according to an embodiment of the disclosure.

Throughout the drawings, like reference numerals may be assigned to like parts, components, and/or structures.

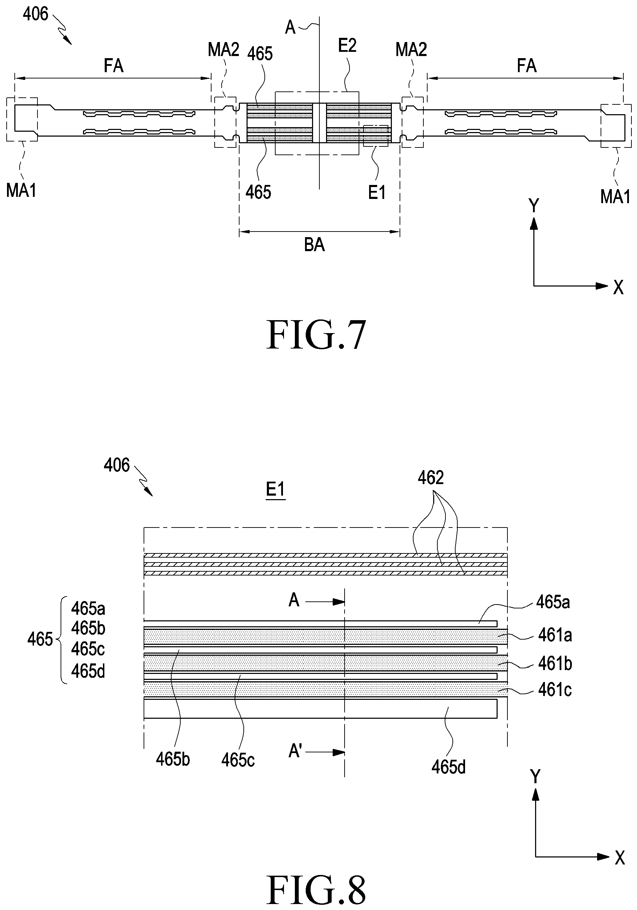

The invention is primarily set out with reference to Figures 7-11. Other embodiments are nevertheless useful for understanding the invention. These embodiments disclose various refinements of the claimed combination of features and should be understood to implicitly include all features according to the wording of claim 1, even if not mentioned explicitly.

### [Mode for the Invention]

In an electronic device including a plurality of housings, lines for connecting electrical/electronic components disposed on different housings may be provided. For example, the lines may supply power or transmit data signals, control signals, and/or communication signals. When the housings are configured to move relative to each other, a flexible printed circuit board may be useful to electrically connect different housings (or electrical/electronic components mounted in the housings). For example, the flexible printed circuit board may have flexibility enough to be deformable between a flat plate shape and a curved plate (or curved surface) shape depending on relative positions of the housings. As the performance of electronic devices is enhanced, e.g., the image quality of displays, the number of pixels of the camera image sensor, and/or sound quality may be advanced and/or, as the communication bands are extended, more lines in the electronic device may be required.

An electromagnetic shielding structure may be provided when transmitting communication signals through the flexible printed circuit board in the electronic device. For example, an electromagnetic shielding structure or a waveguide structure may be provided to signal lines for transmitting communication signals to suppress electromagnetic interference with ambient signal lines and/or to secure stability in transmission of communication signals. The electromagnetic shielding structure (or waveguide structure) in the flexible printed circuit board may be implemented by an array of via conductors disposed around the signal lines. As the frequency of the communication signal increases, the interval between the via conductors may reduce. For example, in wireless communication using mmWave, an electromagnetic shielding structure may be implemented on the signal lines for transmitting communication signals using the via conductors arranged at fairly close intervals on the flexible printed circuit board. However, as the flexible printed circuit board has a structure of being deformed between the flat plate shape and the curved surface shape, relative displacement may occur between the via conductors, and/or the via conductors may be cracked due to repeated deformation. For example, the deformation of the flexible printed circuit board may distort the electromagnetic shielding structure or generate an electromagnetic coupling between signal line and via conductor, deteriorating the stability of communication signal transmission. Further, when the via conductors are arranged at close intervals, the flexibility of the flexible printed circuit board may be decreased, restricting the deformation into the curved surface shape.

An embodiment of the disclosure aims to address the foregoing issues and/or drawbacks and provide advantages described below, providing an electronic device including a flexible printed circuit board to implement stable signal transmission between the housings.

An embodiment of the disclosure may provide an electronic device including a flexible printed circuit board having a stable electromagnetic shielding structure in communication signal transmission.

An embodiment of the disclosure may provide an electronic device including a flexible printed circuit board having flexibility and durability to the degree that it is deformable between the flat plate shape and the curved plate shape while implementing stable signal transmission.

Objects of the disclosure are not limited to the foregoing, and other unmentioned objects would be apparent to one of ordinary skill in the art from the following description.

The following description taken in conjunction with the accompanying drawings may provide an understanding of various exemplary implementations of the claims. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims and equivalent thereto.

The singular forms "a," "an," and "the" are intended to include the plural forms as well, unless the context clearly indicates otherwise. Thus, as an example, "a component surface" may be interpreted as including one or more of the surfaces of a component.

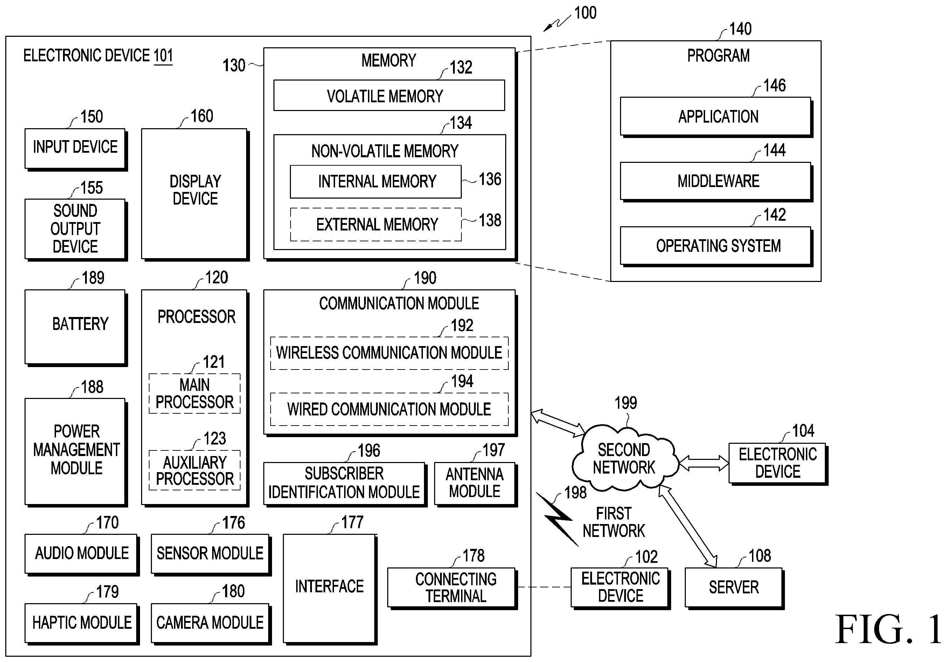

FIG. 1 is a block diagram illustrating an electronic device 101 in a network environment 100 according to an embodiment of the disclosure. Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal According to an embodiment, the display module 160 may include a first display module 351 corresponding to the user's left eye and/or a second display module 353 corresponding to the user's right eye., a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may Include a 'connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module may include an antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

The electronic device according to embodiment(s) of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

An embodiment of the disclosure and terms used therein are not intended to limit the technical features described in the disclosure to specific embodiments, and should be understood to include various modifications, equivalents, or substitutes of the embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1^{st}" and "2^{nd}," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiment(s) of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or Further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

In the following detailed description, a length direction, a width direction, and/or a thickness direction of the electronic device may be mentioned and may be defined as a 'Y-axis direction,' 'X-axis direction', and/or 'Z-axis direction,' respectively. In an embodiment, 'negative/positive (-/+)' may be mentioned together with the Cartesian coordinate system exemplified in the drawings with respect to the direction in which the component is oriented. For example, the front surface of the electronic device and/or housing may be defined as a 'surface facing in the +Z direction,' and the rear surface may be defined as a 'surface facing in the -Z direction'. In an embodiment, the side surface of the electronic device and/or housing may include an area facing in the +X direction, an area facing in the +Y direction, an area facing in the -X direction, and/or an area facing in the -Y direction. In an embodiment, the 'X-axis direction' may mean including both the '-X direction' and the '+X direction'. It should be noted that the directions are so defined with respect to the Cartesian coordinate system shown in the drawings for the sake of brevity of description, and the description of these directions or components do not limit an embodiment(s) of the disclosure. For example, the Cartesian coordinate system may be defined as different from that disclosed in the disclosure depending on the specifications of the electronic device or the user's usage habits.

In the following embodiments, a plurality of housings may be rotatably coupled to be rotatable relative to each other between a first position in which they are folded to face each other and a second position in which they are unfolded side by side. The following description of embodiments with reference to the Cartesian coordinate system may focus primarily on the unfolded state. In the electronic device according to the following embodiments, the folding axis(es) may be understood as substantially parallel to the Y-axis direction. However, embodiment(s) of the disclosure are not limited thereto, and embodiment(s) of the disclosure may be understood as including electronic devices having a structure in which the folding axis(es) is parallel to the X-axis direction.

**In** the following embodiments, the electronic devices illustrated in the Figures have a substantially rectangular shape. However, embodiment(s) of the disclosure are not limited thereto, and embodiment(s) of the disclosure may be understood as including electronic devices having non-rectangular shapes.

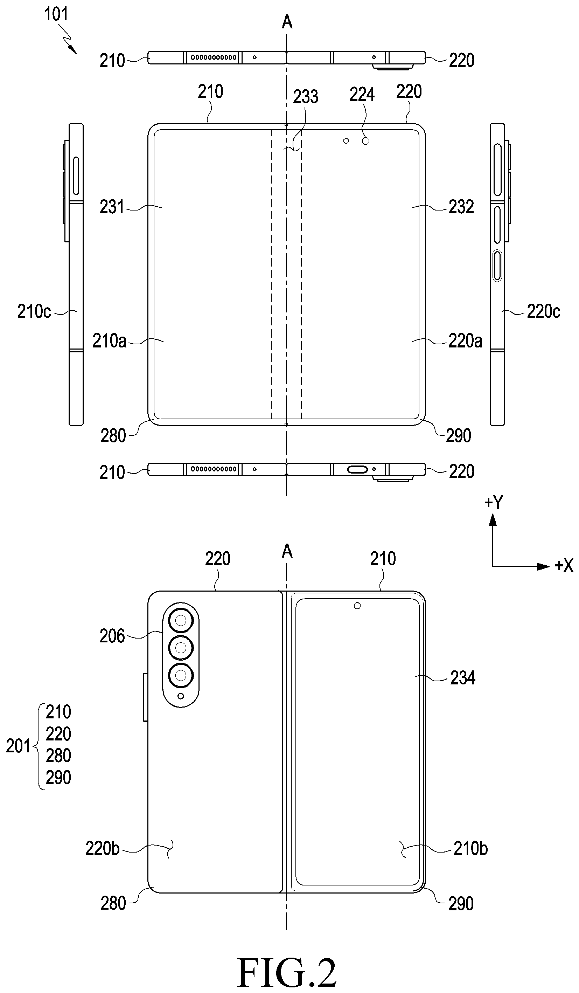

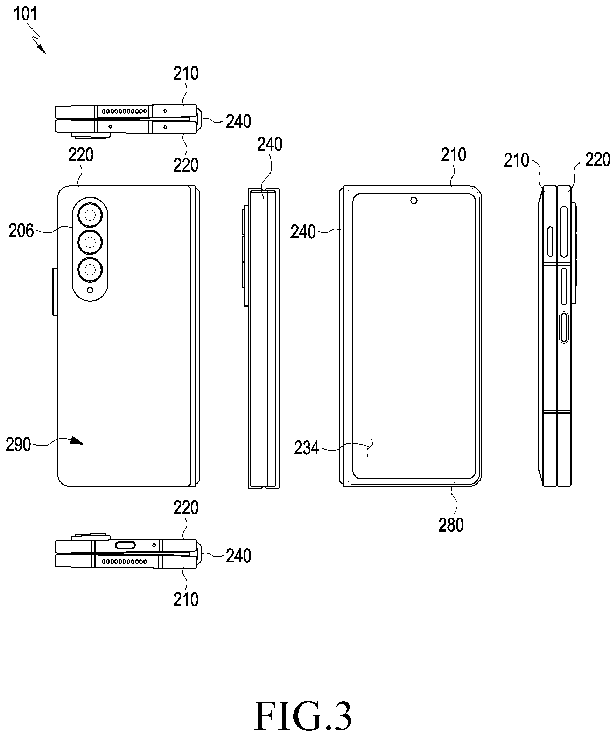

FIG. 2 is a view illustrating an unfolded state of an electronic device according to an embodiment of the disclosure. FIG. 3 is a view illustrating a folded state of an electronic device according to an embodiment of the disclosure. FIGS. 2 and 3 may illustrate the same device, the only difference being whether it is in the unfolded stater or in the folded state.

Referring to FIGS. 2 and 3, an electronic device 101 may include a housing 201, a hinge cover 240 covering a foldable portion of the housing 201, and a display 230 disposed in a space formed by the housing 201. **In** Figure 2, the display is denoted using reference numerals 231, 232, and 233. According to an embodiment, the surface where the screen output from the display 230 is exposed may be defined as a front surface (e.g., the first front surface 210a and the second front surface 220a) of the electronic device 101. A surface opposite to the front surface may be defined as a rear surface (e.g., the first rear surface 210b and the second rear surface 220b) of the electronic device 101. **In** an embodiment, a surface surrounding the space between the front surface and the rear surface may be defined as a side surface (e.g., the first side surface 210c and the second side surface 220c) of the electronic device 101. The side surface of the electronic device 101 may be a side surface of at least one of the first housing 210 or the second housing 220. The electronic device 101 of FIGS. 2 and 3 may be referred to as a foldable electronic device, a portable electronic device, or a portable foldable electronic device. According to an embodiment, the housing 201 may be referred to as a foldable housing. The display 230 may be referred to as a "flexible display."

According to an embodiment, the housing 201 may include a first housing 210, a second housing 220 rotatable with respect to the first housing 210, a first rear cover 280, and a second rear cover 290. The housing 201 of the electronic device 101 are not limited to the shape and coupling shown in FIGS. 2 and 3 but may rather be implemented in other shapes or via a combination and/or coupling of other components. For example, in an embodiment, the first housing 210 and the first rear cover 280 may be integrally formed with each other, and the second housing 220 and the second rear cover 290 may be integrally formed with each other.

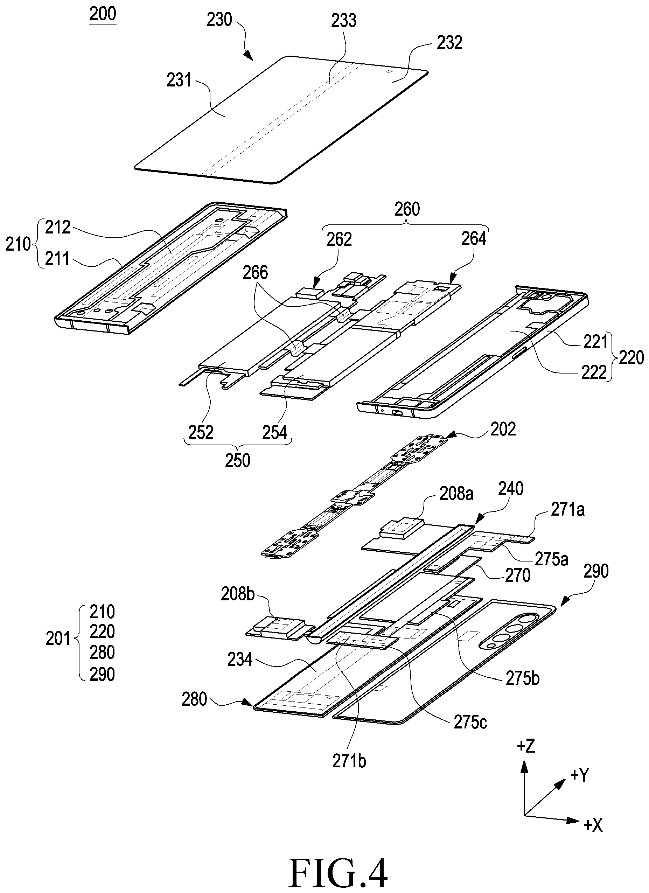

According to an embodiment, the first housing 210 may be connected to a hinge structure (e.g., the hinge assembly 202 of FIG. 4) and may include a first front surface 210a facing in a first direction and a first rear surface 210b facing in a second direction opposite to the first direction. The second housing 220 may be connected to the hinge assembly 202 and may include a second front surface 220a facing in a third direction and a second rear surface 220b facing in a fourth direction opposite to the third direction, and may rotate from the first housing 210 about the hinge assembly 202. Thus, the electronic device 101 may turn into a folded state or unfolded state. In the folded state of the electronic device 101, the first front surface 210a may face the second front surface 220a and, in the unfolded state, the third direction may be identical to the first direction. Hereinafter, unless otherwise mentioned, directions are described based on the unfolded state of the electronic device 101.

According to an embodiment, the first housing 210 and the second housing 220 are disposed on both sides of the folding axis A and be overall symmetrical in shape with respect to the folding axis A. As set forth below, the first housing 210 and the second housing 220 may have different angles or distances formed therebetween depending on whether the electronic device 101 is in the unfolded, folded, or intermediate state. According to an embodiment, the second housing 220 further includes the sensor area 224 where sensors (e.g., front camera) are disposed but, in the remaining area, the second housing 220 may be symmetrical in shape with the first housing 210.

According to an embodiment, there may be provided a plurality of (e.g., two) folding axes A parallel to each other. **In** the disclosure, the folding axis A is provided along the length direction (Y-axis direction) of the electronic device 101, but the direction of the folding axis A is not limited thereto. For example (not shown), the electronic device 101 may include the folding axis extending along the width direction (e.g., X-axis direction).

According to an embodiment, the electronic device 101 may include a structure to which a digital pen (not shown) may be attached. For example, the electronic device 101 may include a magnetic substance configured to attach the digital pen to a side surface of the first housing 210 or a side surface of the second housing 220. According to an embodiment, the electronic device 101 may include a structure into which a digital pen may be inserted. For example, a hole (not shown) into which the digital pen may be inserted may be formed in a side surface of the first housing 210 or a side surface of the second housing 220 of the electronic device 101.

According to an embodiment, the first housing 210 and the second housing 220 may at least partially be formed of a metal or non-metallic material with a rigidity selected to support the display 230. At least a portion formed of metal may provide a ground plane of the electronic device 101 and may be electrically connected with a ground line formed on a printed circuit board (e.g., the board unit 260 of FIG. 4).

According to an embodiments, the sensor area 224 may be formed adjacent to an edge or corner of the second housing 220 and to have a predetermined area. However, the placement, shape, or size of the sensor area 224 is not limited to those illustrated. For example, in another embodiment, the sensor area 224 may be provided in a different corner of the second housing 220 or in any area between the top corner and the bottom corner or in the first housing 210. In an embodiment, components for performing various functions, embedded in the electronic device 101, may be exposed through the sensor area 224 or one or more openings in the sensor area 224 to the front surface of the electronic device 101. In an embodiment, the components may include various kinds of sensors. The sensor(s) may include, e.g., at least one of a front camera, a receiver, or a proximity sensor.

According to an embodiment, the first rear cover 280 may be disposed on one side of the folding axis A on the rear surface of the electronic device 101 and have, e.g., a substantially rectangular periphery which may be surrounded by another structure of the first housing 210. Similarly, the second rear cover 290 may be disposed on the opposite side of the folding axis A on the rear surface of the electronic device 101 and its periphery may be surrounded by another structure of the second housing 220.

According to an embodiment, the first rear cover 280 and/or the second rear cover 290 may be substantially symmetrical in shape with respect to the folding axis (axis A). However, the first rear cover 280 and the second rear cover 290 are not necessarily symmetrical in shape. In an embodiment, the electronic device 101 may include the first rear cover 280 and the second rear cover 290 in different shapes, not symmetrical.

According to an embodiment, the first rear cover 280, the second rear cover 290, the first housing 210, and the second housing 220 may provide a space where various components (e.g., a printed circuit board or battery) of the electronic device 101 may be disposed. According to an embodiment, one or more components may be arranged or visually exposed on/through the rear surface of the electronic device 101. For example, at least a portion of a sub display 234 may be visually exposed through at least a portion of the first rear cover 280. **In** another embodiment, one or more components or sensors may be visually exposed through at least a portion of the first rear cover 290. According to various embodiments, the sensor may include a proximity sensor and/or a camera module 206 (e.g., rear camera).

According to an embodiment, a front camera exposed to the front surface of the electronic device 101 through one or more openings provided in the sensor area 224 or the camera module 206 exposed through at least a portion of the second rear cover 290 may include one or more lenses, an image sensor, and/or an image signal processor. In an embodiment, two or more lenses (an infrared (IR) camera, a wide-angle lens, and a telephoto lens) and image sensors may be disposed on one surface of the electronic device 101.

According to an embodiment, the hinge cover 240 may be disposed between the first housing 210 and the second housing 220 to hide the internal components (e.g., the hinge assembly 202 of FIG. 4). According to an embodiment, the hinge cover 240 may be hidden by a portion of the first housing 210 and second housing 220 or be exposed to the outside depending on the state (e.g., the unfolded state (e.g., flat state) or folded state) of the electronic device 101.

According to an embodiment, as shown in FIG. 2, in the unfolded state of the electronic device 101, the hinge cover 240 may be hidden, and thus not exposed, by the first housing 210 and the second housing 220. As another example, as shown in FIG. 3, in the folded state (e.g., a fully folded state) of the electronic device 101, the hinge cover 240 may be exposed to the outside between the first housing 210 and the second housing 220. As another example, in an intermediate state in which the first housing 210 and the second housing 220 are folded with a certain angle, the hinge cover 240 may be partially exposed to the outside between the first housing 210 and the second housing 220. However, in this case, the exposed area may be smaller than that in the completely folded state. In an embodiment, the hinge cover 240 may include a curved surface.

According to an embodiment, the display 230 may be disposed in a space formed (or defined) by the housing 201. For example, the display 230 may be seated on a recess provided by the housing 201 and may form most of the front surface of the electronic device 101. Thus, the front surface of the electronic device 101 may include the display 230 and a partial area of the first housing 210 and a partial area of the second housing 220, which are adjacent to the display 230. The rear surface of the electronic device 101 may include a first rear cover 280, a partial area of the first housing 210 adjacent to the first rear cover 280, a second rear cover 290, and a partial area of the second housing 220 adjacent to the second rear cover 290.

According to an embodiment, the display 230 may include a plurality of display areas spaced apart from each other. For example, the display 230 may include a first display area 231 disposed on the first housing 210, a second display area 232 disposed on the second housing 220, and a folding area 233. According to an embodiment, the first display area 231 and the second display area 232 may rotate about the folding axis A.

According to an embodiment, the display 230 may mean a display at least a portion of which may be transformed into a flat or curved surface. For example, the display 230 may be a foldable or flexible display. According to an embodiment, the display 230 may include a folding area 233, a first display area 231 disposed on one side of the folding area 233 (e.g., the left side of the folding area 233 of FIG. 2), and a second display area 232 disposed on the opposite side of the folding area 233 (e.g., the right side of the folding area 203 of FIG. 2). However, the segmentation of the display 230 is merely an example, and the display 230 may be divided into a plurality of (e.g., four or more, or two) areas depending on the structure or function of the display 200. For example, in the embodiment illustrated in FIG. 2, the display 230 may be divided into the areas by the folding area 233 or folding axis A extending in parallel with the Y axis but, in another embodiment, the display 230 may be divided into the areas with respect to another folding area (e.g., a folding area parallel with the X axis) or another folding axis (e.g., a folding axis parallel with the X axis). According to an embodiment, the display 230 may be coupled with or disposed adjacent to a touch detection circuit, a pressure sensor capable of measuring the strength (pressure) of touches, and/or a digitizer (not shown) for detecting a magnetic field-type stylus pen.

According to an embodiment, the first display area 231 and the second display area 232 may be overall symmetrical in shape with respect to the folding area 233. According to an embodiment (not shown), unlike the first display area 231, the second display area 232 may include a notch depending on the presence of the sensor area 224, but the rest may be substantially symmetrical in shape with the first display area 231. For example, the first display area 231 and the second display area 232 may include symmetrical portions and asymmetrical portions.

Described below are the operation of the first housing 210 and the second housing 220 and each area of the display 230 depending on the state (e.g., the unfolded state (or flat state) and folded state) of the electronic device 101.

According to an embodiment, when the electronic device 101 is in the unfolded state (flat state) (e.g., FIG. 2), the first housing 210 and the second housing 220 may be disposed to face in the same direction while being angled substantially at 180 degrees therebetween. The surface of the first display area 231 and the surface of the second display area 232 of the display 230 may be angled at 180 degrees therebetween while facing in the same direction (e.g., forward of the front surface of the electronic device). The folding area 233 may form the same plane with the first display area 231 and the second display area 232.

According to an embodiment, when the electronic device 101 is in the folded state (e.g., FIG. 3), the first housing 210 and the second housing 220 may be disposed to face each other. The surface of the first display area 231 and the surface of the second display area 232 of the display 230 may be angled at a small angle (e.g., an angle between about 0 degrees and about 10 degrees) therefrom while facing each other. **In** the folded state of the electronic device 101, at least a portion of the folding area 233 may be formed as a curved surface having a predetermined curvature.

According to an embodiment, when the electronic device 101 is in the intermediate state (not shown), the first housing 210 and the second housing 220 may be disposed at a certain angle therebetween. The surface of the first display area 231 of the display 230 and the surface of the second display area 232 may form an angle which is larger than the angle in the folded state and smaller than the angle in the unfolded state. The folding area 233 may at least partially have a curved surface with a predetermined curvature and, in this case, the curvature may be smaller than that when it is in the folded state.

FIG. 4 is an exploded perspective view illustrating an electronic device according to an embodiment of the disclosure;

Referring to FIG. 4, an electronic device 200 (e.g., the electronic device 101 of FIGS. 1 to 3) may include a housing 201, a display 230, a hinge assembly 202, a battery 250, and a board unit 260. For example, the housing 201 may include a first housing 210, a second housing 220, a first rear cover 280, and a second rear cover 290. The configuration of the first housing 210, the second housing 220, the hinge cover 240, the first rear cover 280, and the second rear cover 290 of FIG. 4 may be identical in whole or part to the configuration of the first housing 210, the second housing 220, the hinge cover 240, the first rear cover 280, and/or the second rear cover 290 of FIG. 2 and/or FIG. 3.

According to an embodiment, the first housing 210 and the second housing 220 may be assembled together to be coupled to two opposite sides of the hinge assembly 202. For example, the hinge assembly 202 may be disposed in a hinge area between the first housing 210 and the second housing 220 to rotatably couple the first housing 210 and the second housing 220. Here, the 'hinge area' may refer to a space where the hinge assembly 202 is disposed, an area at least partially surrounded by the hinge cover 240, and/or a space between the hinge cover 240 and the folding area 233 of the display 230. **In** an embodiment, the hinge area may be understood as a space disposed substantially corresponding to the folding area 233.

According to an embodiment, the first housing 210 may include a first supporting area 212 (e.g., a first supporting member) that may support the components (e.g., the first circuit board 262 and/or the first battery 252) of the electronic device 101 and a first sidewall 211 surrounding at least a portion of the first supporting area 212. The first sidewall 211 may include a first side surface (e.g., the first side surface 210c of FIG. 2) of the electronic device 101. According to an embodiment, the second housing 220 may include a second supporting area 222 that may support the components (e.g., the second circuit board 264 and/or the second battery 254) of the electronic device 101 and a second sidewall 221 surrounding at least a portion of the second supporting area 222. The second sidewall 221 may include a second side surface (e.g., the second side surface 220c of FIG. 2) of the electronic device 101.

According to an embodiment, although not shown, the first housing 210 may include a first waterproofing member disposed in the first supporting area 212 and/or the second housing 220 may include a second waterproofing member disposed in the second supporting area 222. The first waterproofing member and/or the second waterproofing member may be disposed in the gaps between the display 230 and the supporting area(s) 212 and 222 to suppress influx of moisture or foreign bodies from the outside to the inside of the first housing 210 and/or the second housing 220.

According to an embodiment, the display 230 may include a first display area 231, a second display area 232, and/or a folding area 233. The configuration of the first display area 231, the second display area 232, and the folding area 233 of FIG. 4 may be identical in whole or part to the configuration of the first display area 231, the second display area 232, and the folding area 233 of FIG. 2 and/or FIG. 3.

According to an embodiment, the electronic device 200 may further include a sub display 234. In an embodiment, the sub display 234 may display screen in a different direction from the display areas 231 and 232. For example, the sub display 234 may output screen in a direction opposite to the first display area 231. According to an embodiment, the sub display 234 may be disposed on the first rear cover 280.

According to an embodiment, the battery 250 may include a first battery 252 disposed in the first housing 210 and a second battery 254 disposed in the second housing 220. According to an embodiment, the first battery 252 may be connected with the first circuit board 262, and the second battery 254 may be connected to the second circuit board 264. According to an embodiment, the battery 250 may supply power to at least one component of the electronic device 101. According to an embodiment, the battery 250 may include, for example, a primary cell which is not rechargeable, a secondary cell which is rechargeable, or a fuel cell.

According to an embodiment, the board unit 260 may include a first circuit board 262 disposed in the first housing 210 and a second circuit board 264 disposed in the second housing 220. According to an embodiment, the first circuit board 262 and the second circuit board 264 may be electrically connected by at least one flexible printed circuit board 266. According to an embodiment, at least a portion of the flexible printed circuit board 266 may be disposed across the hinge area or hinge structure (e.g., the hinge assembly 202). According to an embodiment, the first circuit board 262 and the second circuit board 264 may be disposed in a space formed by the first housing 210, the second housing 220, the first rear cover 280, and the second rear cover 290. Components for implementing various functions of the electronic device 101 may be disposed on the first circuit board 262 and the second circuit board 264.

According to an embodiment, the electronic device 101 may include speakers 208a and 208b. According to an embodiment, the speakers 208a and 208b may convert the electric signal into sound. According to an embodiment, the speakers 208 and 208b may be disposed in a space formed by the first housing 210, the second housing 220, the first rear cover 280, and the second rear cover 290. According to an embodiment, the speakers 208a and 208b may include an upper speaker 208a positioned in an upper portion (+Y direction) of the electronic device 101 and a lower speaker 208b positioned in a lower portion (-Y direction) of the electronic device 101. In the disclosure, the speakers 208a and 208b are illustrated as positioned in one housing (e.g., the first housing 210 of FIG. 4), but this is an optional structure. For example, the speakers 208a and 208b may be positioned in at least one of the first housing 210 or the second housing 220. The configuration of the speakers 208a and 208b of FIG. 4 may be identical in whole or part to the configuration of the sound output module 155 of FIG. 1.

According to an embodiment, the electronic device 101 may include a rear member 270 (or rear case). According to an embodiment, the rear member 270 may be disposed in the housing 201 (e.g., the second housing 220). According to an embodiment, the rear member 270 may receive at least one antenna 275.

According to an embodiment, the electronic device 101 may include an antenna 275. The antennas 275a and 275b may include, e.g., an ultra-wide band (UWB) antenna 275a, a near-field communication (NFC) antenna, a wireless charging antenna, and/or a magnetic secure transmission (MST) antenna 275b. The antenna 275 may perform short-range communication with, e.g., an external device or may wirelessly transmit or receive power necessary for charging.

According to an embodiment, an antenna structure may be formed by a portion of the housing 201 or a combination thereof. For example, the antenna 275 may include a communication antenna 275c at least a portion of which is exposed to the outside and which forms at least a portion of the exterior of the electronic device 101. The communication antenna 275c may be used for communication (e.g., Wi-Fi) with an external electronic device. For example, the communication antenna 275c may be positioned on the upper portion 271a or the lower portion 271b of the rear member 270.

In the following detailed description, a configuration in which a pair of housings (or referred to as a 'housing structure') are coupled to be rotatable by a hinge structure (or referred to as a 'hinge assembly 202') is described as an example. However, it should be noted that the electronic device according to various embodiments of the disclosure is not limited thereto. For example, the electronic device according to embodiment(s) of the disclosure may include three or more housings. In the embodiment disclosed below, a "pair of housings" may refer to two rotatably-coupled housings among three or more housings.

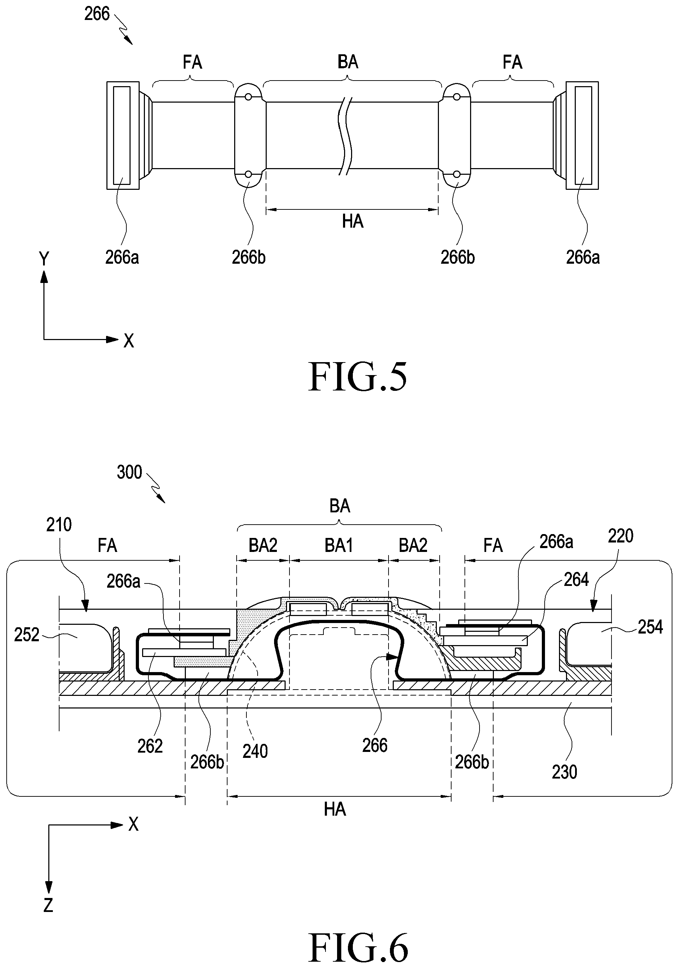

FIG. 5 is a view illustrating a flexible printed circuit board 266 (e.g., the flexible printed circuit board 266 of FIG. 4) of an electronic device (e.g., the electronic device 101 or 200 of FIGS. 1 to 4) according to an embodiment. FIG. 6 is a view illustrating an unfolded state of an electronic device 300 (e.g., the electronic device 101 or 200 of FIGS. 1 to 4) according to an embodiment.

Referring to FIGS. 5 and 6, the flexible printed circuit board 266 may include a bending portion BA and/or a fixing portion FA. The bending portion BA may refer to, e.g., a portion disposed corresponding to the hinge area HA and at least partially deformed between a flat plate shape and a curved surface shape. The fixing portion FA is, e.g., a portion disposed inside the first housing 210 or the second housing 220 and may maintain a substantially fixed shape. For example, in an operation in which the first housing 210 and the second housing 220 move or rotate relative to each other between a first position (e.g., the state illustrated in FIG. 3) and a second position (e.g., the state illustrated in FIG. 2), the fixing portion FA may maintain the initially assembled shape. In an embodiment, the fixing portion FA may be manufactured in a flat plate shape, assembled, and then disposed in the shape illustrated in FIG. 6. In an embodiment, when the bending portion BA is deformed, a portion of the fixing portion FA may be moved or deformed, so that the load applied to the bending portion may be dispersed due to the deformation. For example, although referred to as a "fixing portion", embodiments of the disclosure are not limited thereto, and as a portion of the fixing portion FA is moved or deformed, deformation or load due to relative movement or rotation of the first housing 210 and the second housing 210 may be suppressed from being concentrated on the bending portion BA in the flexible printed circuit board 266.

According to an embodiment, in the electronic device 200 of FIG. 4, the communication module 190 (e.g., a millimeter wave communication modem) of FIG. 1 may be disposed in any one of the housings 210 and 220, and a millimeter wave communication antenna may be disposed in the other one of the housings 210 and 220. In this case, the flexible printed circuit board 266 may transfer wireless communication signals between the communication module 190 and the millimeter wave communication antenna across the hinge area HA. In an embodiment, in the electronic device 200, a portion of at least one of the housings 210 and 220 may function as an antenna. In an embodiment, the portion of the electronic device 200 that functions as an antenna may implement a side surface of at least one of the housings 210 and 220. In an embodiment, the portion of the electronic device 200 that functions as an antenna may be disposed to be adjacent to a side surface of at least one of the housings 210 and 220 and/or to face in a direction crossing the Z-axis. For example, the portion of the electronic device 200 that functions as an antenna may be implemented by portions of the housings 210 and 220, or may be disposed adjacent to edges of the housings 210 and 220 while being manufactured in the form of a component separate from the housings 210 and 220. In an embodiment, "the portion of the electronic device 200 that functions as an antenna is implemented by portions of the housings 210 and 220" may be understood as including, e.g., an example in which the portion functioning as an antenna is disposed to form a side surface of at least one of the housings 210 and 220. In an embodiment, for the antenna manufactured in the form of a component separate from the housings 210 and 220 and disposed adjacent to the edge of the housings 210 and 220, Korean Patent Application Publication No. 10-2020-0132041 (published on November 25, 2020; U.S. Patent No. 11,013,149 (issued on May 18, 2021)) filed by the applicant may be referred to.

According to an embodiment, in a portion crossing an area where the hinge structure (or the hinge assembly 202) is disposed, the flexible printed circuit board 266 may have higher flexibility than the remaining portion. For example, as the bending portion BA (e.g., a portion crossing the area where the hinge structure (or the hinge assembly 202) is disposed) is manufactured to be more flexible than the fixing portion FA, the flexible printed circuit board 266 may be deformed into a corresponding shape according to relative movement or rotation of the housings 210 and 220, thereby providing stability in wireless communication signal transmission. The configuration of the flexible printed circuit board 266 is described again with reference to embodiments to be described below.

According to an embodiment, the flexible printed circuit board 266 may include connectors 266a provided at two opposite ends. The connectors 266a may be connected to, e.g., a printed circuit board (e.g., the first circuit board 262 or the second circuit board 264 of FIG. 4) in the first housing 210 or the second housing 220. In an embodiment, when a flip-lock type connector is provided on the first circuit board 262 or the second circuit board 264, the connectors 266a of the flexible printed circuit board 266 may be omitted, and a plurality of connecting pads provided on surfaces at two opposite ends of the flexible printed circuit board 266 may be provided.

According to an embodiment, the flexible printed circuit board 266 may include fixing pieces 266b provided on at least one surface at designated gaps between the connectors 266a. In an embodiment, the fixing pieces 266b may be disposed at a boundary between the bending portion BA and the fixing portion FA (e.g., any one of the fixing portions FA). For example, the fixing pieces 266b may be fixed inside any one of the first housing 210 and the second housing 220, thereby maintaining the arrangement shape of the fixing portion(s) FA. In an embodiment, the fixing pieces 266b may include a plate formed of a metal or synthetic resin material or an adhesive tape. In an embodiment, the fixing pieces 266b may be omitted, and a portion of the flexible printed circuit board 266 may be fixed between other structures such as a sidewall (e.g., the first sidewall 211 or the second sidewall 221 of FIG. 4) or a supporting area (e.g., the first supporting area 212 or the second supporting area 222 of FIG. 4). For example, in fixing or maintaining the arrangement shape of the flexible printed circuit board 266 inside the first housing 210 or the second housing 220, it should be noted that the structure provided with the fixing piece(s) 266b does not limit the embodiment(s) of the disclosure.

According to an embodiment, inside the first housing 210 or the second housing 220, the flexible printed circuit board 266 (e.g., the fixing portion FA) may be disposed between the display 230 and the circuit boards 262 and 264 and/or between the batteries 252 and 254 and the circuit boards 262 and 264, and may be connected to the circuit boards 262 and 264 in the -Z direction. For example, the fixing piece(s) 266b may fix a portion of the flexible printed circuit board 266 inside the housings 210 and 220 between the circuit boards 262 and 264 and the display 230. In the illustrated embodiment, the connectors 266a are illustrated as being connected to one surface of the first circuit board 262 or the second circuit board 264 in the -Z direction, but the embodiment(s) of the disclosure are not limited thereto. For example, at least one of the connectors 266a may be connected to another surface of the first circuit board 262 or the second circuit board 264 in the +Z direction.

According to an embodiment, according to the folded state or the unfolded state of the housings 210 and 220, the bending portion BA may be deformed into a designated shape inside the electronic device 300 (e.g., the hinge cover 240). Although not shown, when the housings 210 and 220 are in the folded state, the bending portion BA may be substantially shaped like the letter 'U'. As illustrated in FIG. 6, when the housings 210 and 220 are in the unfolded state, it may be identified that the portion indicated by "BA1" in the bending portion BA is generally a curved shape close to a flat plate, and the portion indicated by "BA2" is a letter "S" shape. For example, in a relative movement or deformation of the housings 210 and 220, the BA2 portion may be deformed more than the BA1 portion is. In an embodiment, the flexible printed circuit board 266 may be at least partially fixed to the hinge cover 240. For example, the BA1 portion having a relatively small change in curvature in the relative movement or deformation of the housings 210 and 220 may be fixed inside the hinge cover 240.

As described above, when the flexible printed circuit board 266 is designed or manufactured to transmit a communication signal, via conductors may be arranged around a signal line for communication signal transmission to implement an electromagnetic shielding structure. As the frequency of the communication signal increases, the interval between the via conductors may decrease, which may limit deformation of the flexible printed circuit board. In an embodiment, when an electromagnetic shielding structure (or waveguide structure) is implemented using via conductors and a communication signal is transmitted through a signal line, deformation of the flexible printed circuit board may cause a performance deviation of the communication signal. As the interval between the via conductors decreases, and the frequency of the transmitted communication signal increases, the deviation in communication performance due to deformation (e.g., relative displacement of the via conductors) may increase. For example, when a millimeter wave signal is transmitted through the flexible printed circuit board 266, an electromagnetic shielding structure using via conductors may decrease flexibility of the flexible printed circuit board, and it may be difficult to secure stable communication performance. In an embodiment, the flexible printed circuit board 266 may provide an electromagnetic shielding environment or a waveguide structure to signal lines using the conductive material of the electromagnetic shielding layer adjacent to the layer where signal lines are arranged, thereby securing flexibility of the flexible printed circuit board 266 and implementing stable communication performance. An electromagnetic shielding environment or a waveguide structure according to an embodiment(s) of the disclosure is described with reference to FIGS. 7 to 11. In describing an embodiment to be described below, the electronic device 101, 200, or 300 of FIGS. 1 to 4 and/or 6 and the flexible printed circuit board 266 of FIGS. 4 to 6 may be referred to.

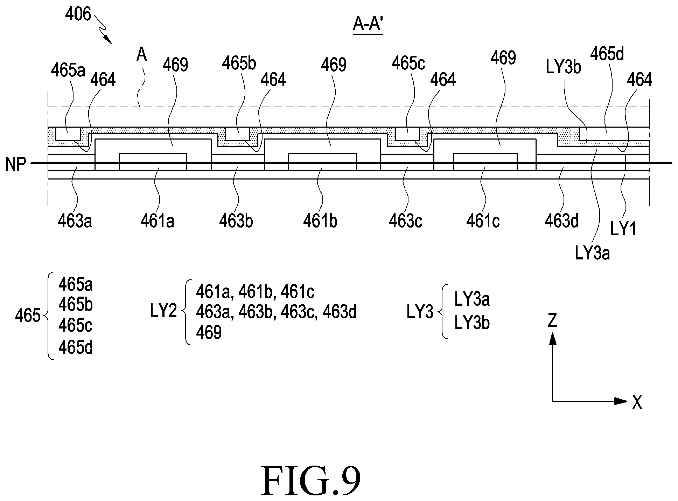

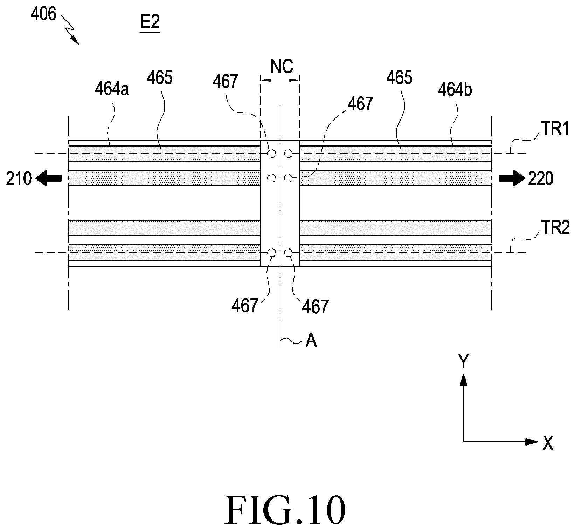

FIG. 7 is a view illustrating a flexible printed circuit board 406 (e.g., the flexible printed circuit board 266 of FIGS. 4 to 6) of an electronic device (e.g., the electronic device 101, 200, or 300 of FIGS. 1 to 4 and/or 6) according to an embodiment of the disclosure. FIG. 8 is an enlarged view illustrating portion E1 of FIG. 7 in a flexible printed circuit board 406 of an electronic device 300 according to an embodiment of the disclosure. FIG. 9 is a cross-sectional view taken along line A-A' of FIG. 8 in a flexible printed circuit board 406 of an electronic device 300 according to an embodiment of the disclosure. FIG. 10 is an enlarged view illustrating portion E2 of FIG. 7 in a flexible printed circuit board 406 of an electronic device 300 according to an embodiment of the disclosure.

In FIG. 7, the portion(s) indicated by 'MA1' may be, e.g., a portion connected to any one of the circuit boards 262 and 264 of FIG. 4. In an embodiment, the connector 266a of FIG. 5 may be disposed on the portion indicated by 'MA1'. In FIG. 7, the portion indicated by 'MA2' may be an example of a portion fixed inside any one of the housings 210 and 220 of FIG. 4 (e.g., the supporting areas 212 and 222 of FIG. 4). In an embodiment, the fixing piece 266b of FIG. 5 may be disposed on the portion indicated by 'MA2'. As mentioned above, the connector 266a and/or the fixing piece 266b of FIG. 5 are illustratively mentioned, and it should be noted that the embodiment(s) of the disclosure are not limited thereto. For example, the connector 266a of FIG. 5 may be omitted according to the structure of the counterpart connectors disposed on the circuit boards 262 and 264, and when a binding structure such as a clip or a leaf spring is provided inside the housings 210 and 220, the fixing piece 266b may be omitted.

Referring to FIGS. 7 to 10, a flexible printed circuit board 406 (e.g., the flexible printed circuit board 266 of FIGS. 4 to 6) includes a first layer LY1 (e.g., a substrate layer) provided as a base substrate, a second layer LY2 (e.g., a signal line layer) including one or more signal lines 461a, 461b, and 461c and/or one or more ground lines 463a, 463b, 463c, and 463d, a third layer LY3 (e.g., a shielding layer) provided as an electromagnetic shielding layer, and/or at least one elastomeric line 465; 465a, 465b, 465c, and 465d, thereby suppressing damage to the signal lines 461a, 461b, and 461c and/or the ground lines 463a, 463b, 463c, and 463d while securing durability despite repeated deformation. According to the wording of claim 1 at least one elastomeric line 465; 465a, 465b, 465c, and 465d is formed in a recess area (e.g., the groove 464 of FIG. 9) provided in the third layer LY3. In an embodiment, a configuration including at least one elastomeric line 465; 465a, 465b, 465c, and 465d may be referred to as an "elastomeric line layer". In an embodiment, it may be understood that the elastomeric line layer providing the at least one elastomeric line 465; 465a, 465b, 465c, and 465d is partially received in one of the second layer LY2 and the third layer LY3. For example, the recess area may be provided in any one of the second layer LY2 and the third layer LY3, and a portion of the elastomeric line layer may be received in the recess area.

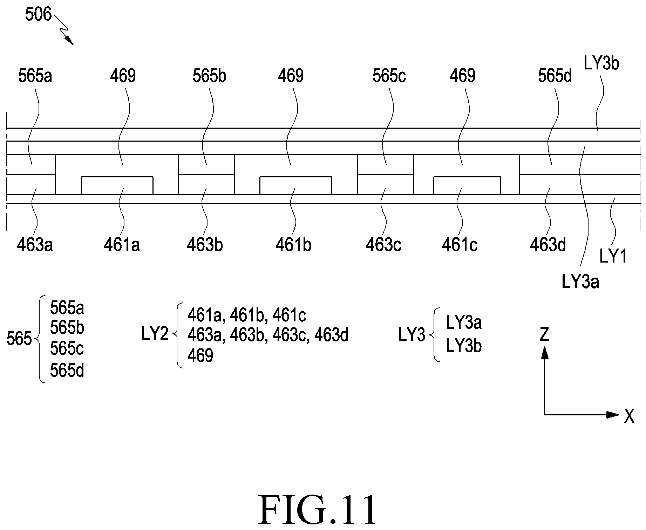

In an embodiment, the elastomeric line 465 may be disposed at a position corresponding to at least one of the ground lines 463a, 463b, 463c, and 463d. For example, among the ground lines 463a, 463b, 463c, and 463d, the elastomeric line(s) 465 may be provided to correspond to the ground line(s) 463a, 463b, 463c, and 463d disposed around the signal lines 461a, 461b, and 461c for communication signal transmission. In an embodiment, as is described with reference to FIG. 11, the elastomeric lines 465 may electrically connect the third layer LY3 to the ground line(s) 463a, 463b, 463c, and 463d adjacent to the signal line(s) 461a, 461b, and 461c for communication signal transmission. In an embodiment, the elastomeric line 465 may be disposed at least partially in the bending portion BA of the flexible printed circuit board 406. In an embodiment, the elastomeric line 465 may extend from the bending portion BA (or a position corresponding to the hinge area HA) on one surface (e.g., the surface of the third layer LY3) of the flexible printed circuit board 406 in a direction substantially perpendicular to the folding axis A. In an embodiment, it may be understood that a portion (e.g., the fixing portion(s) FA) of the flexible printed circuit board 406 is disposed inside the first housing 210 or the second housing 220.

According to an embodiment, the flexible printed circuit board 406 may include a bending portion BA and fixing portions FA respectively extending from two opposite ends of the bending portion BA. It has been described with reference to FIGS. 5 and 6 that a fixing piece(s) 266b may be provided between the bending portion BA and the fixing portion(s) VA. In an embodiment, the elastomeric line(s) 465 may be provided substantially on the surface of the flexible printed circuit board 406, e.g., on the surface of the third layer LY3. However, the embodiment(s) of the disclosure are not limited thereto, and an additional layer (not shown) may be provided on the surface of the elastomeric line 465 or the surface of the third layer LY3.

According to an embodiment, the first layer LY1 is, e.g., a base such as a polyimide film, and the second layer LY2 (e.g., the signal line(s) 461a, 461b, and 461c and/or the ground line(s) 463a, 463b, 463c, and 463d) may be implemented on the first layer LY1. For example, a printed circuit pattern designed by etching an electrically conductive thin film formed by coating, plating, or depositing an electrically conductive material (e.g., copper (Cu), silver (Ag), and/or gold (Au)) on the first layer LY1 may be implemented. In an embodiment, the signal lines 461a, 461b, and 461c of the printed circuit pattern may be allocated for communication signal transmission, and in this case, the signal lines 461a, 461b, and 461c and the ground lines 463a, 463b, 463c, and 463d may be alternately arranged on the first layer LY1. In an embodiment, when the flexible printed circuit board 406 is disposed in the electronic device 300, it may be understood that the signal lines 461a, 461b, and 461c and the ground lines 463a, 463b, 463c, and 463d are arranged along the folding axis A direction. In an embodiment, it may be understood that the signal lines 461a, 461b, and 461c and the ground lines 463a, 463b, 463c, and 463d extend along a direction (e.g., the X-axis direction) crossing the folding axis A.

According to an embodiment, the line indicated by "462" in the printed circuit pattern may be allocated as the line for supplying data signals, various control signals, and/or power. FIG. 8 illustrates a configuration in which the signal lines 461a, 461b, and 461c and the elastomeric lines 465 are visually exposed, but this is to more clearly illustrate relative positions, and it may be understood that the signal lines 461a, 461b, and 461c are substantially concealed. In an embodiment, it may be understood that the signal lines 461a, 461b, and 461c and the ground lines 463a, 463b, 463c, and 463d are alternately arranged in the second layer LY2, and the elastomeric lines 465 are substantially disposed at positions corresponding to at least one of the ground lines 463a, 463b, 463c, and 463d.

According to an embodiment, the third layer LY3 may be provided on the second layer LY2 and may be disposed to at least partially surround an area or space in which the signal lines 461a, 461b, and 461c are disposed, thereby providing an electromagnetic shielding environment to the signal lines 461a, 461b, and 461c and/or implementing a waveguide structure. For example, the third layer LY3 may provide an electromagnetic shielding structure between any signal line among the signal lines 461a, 461b, and 461c and another signal line adjacent thereto. In an embodiment, when the third layer LY3 provides an electromagnetic shielding structure to the first signal line among the signal lines 461a, 461b, and 461c, the corresponding electromagnetic shielding structure may function as a waveguide structure in which the first signal line is embedded. For example, the third layer LY3 may contribute to increasing stability of communication signal transmission while providing an electromagnetic shielding structure. In an embodiment, since the via conductors are omitted and the electromagnetic shielding structure and/or the waveguide structure is implemented by the third layer LY3, the flexible printed circuit board 406 may provide a communication signal (e.g., an RF signal or an mmWave signal) transmission function. In an embodiment, as the via conductors are omitted, the flexible printed circuit board 406 may be flexible enough to be deformed according to the deformation caused by the relative movement of the housings 210 and 220.

According to an embodiment, the third layer LY3 may be disposed to contact the ground lines 463a, 463b, 463c, and 463d without contacting the signal lines 461a, 461b, and 461c, thereby implementing a more stable electromagnetic shielding structure (or waveguide structure). In an embodiment, the second layer LY2 may include an insulating material layer 469 provided to surround at least portion of at least one of the signal lines 461a, 461b, and 461c and/or at least portion of at least one of the ground lines 463a, 463b, 463c, and 463d. For example, in disposing the third layer LY3, the signal lines 461a, 461b, and 461c may be substantially insulated from the third layer LY3, and the ground lines 463a, 463b, 463c, and 463d may be electrically connected or in direct contact with the third layer LY3. For example, the insulating material layer 469 may be disposed to substantially surround the signal lines 461a, 461b, and 461c, and may be disposed to partially surround the ground lines 463a, 463b, 463c, and 463d. Accordingly, the third layer LY3 may include at least one groove 464 formed in a surface at a position in contact with the ground line(s) 463a, 463b, 463c, and 463d. When viewed in plan view of FIG. 8 or cross-sectional view of FIG. 9, grooves 464 respectively may be provided in two opposite side areas of the signal line(s) 461a, 461b, and 461c and/or an area between two adjacent signal lines 461a, 461b, and 461c. The groove(s) 464 may be at least partially filled with, e.g., an elastomer, and the elastomeric line(s) 465 may be substantially implemented by the groove(s) 464 or the elastomer filling at least a portion of the grooves 464. In an embodiment, the elastomer may include rubber, such as styrene butadiene rubber (SBR), butadiene rubber (BR), high butadiene rubber (HBR), nitrile rubber, fluoro elastomer, polychloroprene rubber, ethylene propylene terpolymer (EPM), and/or silicone rubber. For example, when n (where 'n' is a natural number) signal lines 461a, 461b, and 461c are disposed, n+1 ground lines 463a, 463b, 463c, and 463d, n+1 grooves 464, and/or n+1 elastomeric lines 465 may be provided.

According to the wording of claim 1, the third layer LY3 includes an insulation layer LY3b and a conductive layer LY3a. For example, the conductive layer LY3a may be disposed between the insulation layer LY3b and the second layer LY2, so as to be protected from the external environment by the insulation layer LY3b and may be in direct contact with at least one of the ground lines 463a, 463b, 463c, and 463d. When the flexible printed circuit board 406 or the third layer LY3 includes the groove(s) 464, it may be understood that the groove(s) 464 are substantially provided in the insulation layer LY3b.

According to an embodiment, when the housings 210 and 220 are relatively moved or deformed, e.g., when the flexible printed circuit board 406 is deformed between a flat plate shape and a curved surface shape, one surface (e.g., a surface facing in the +Z direction) of the flexible printed circuit board 406 may be deformed to be concave, and another surface (e.g., a surface facing in the -Z direction) of the flexible printed circuit board 406 may be deformed to be convex. In this deformation, a compressive force may act on the concavely deformed surface and a tensile force may act on the convexly deformed surface. In an embodiment, between the concavely deformed surface and the convexly deformed surface, there may be a surface (or area) on which a compressive force or a tensile force does not substantially act (hereinafter, referred to as a "neutral plane NP"). Even if the flexible printed circuit board 406 is deformed, durability or reliability may be enhanced by suppressing a compressive force or a tensile force from acting on the second layer LY2 (e.g., the signal lines 461a, 461b, and 461c and/or the ground lines 463a, 463b, 463c, and 463d).

In an embodiment of the disclosure, the groove(s) 464 and/or the elastomeric line(s) 465 may control the position of the neutral plane NP. For example, by adjusting the width and thickness of the elastomeric line(s) 465, the neutral plane NP may get close to or away from the folding axis A. In an embodiment, the elastomeric line(s) 465 may control the neutral plane NP to be positioned in the second layer LY2. For example, the signal lines 461a, 461b, and 461c and/or the ground lines 463a, 463b, 463c, and 463d may be positioned substantially on the neutral plane NP. Accordingly, even if the flexible printed circuit board 406 is deformed, a compressive force or a tensile force may not substantially act on the signal lines 461a, 461b, and 461c and/or the ground lines 463a, 463b, 463c, and 463d.

According to an embodiment, as illustrated in FIG. 10, the groove(s) 464 may include a first groove 464a and a second groove 464b disposed in one straight trajectory TR1 and TR2 or one curved trajectory. Here, the 'trajectory TR1, TR2' may be understood as a trajectory in which the elastomeric line 465 extends or a trajectory in which the elastomeric lines 465 are arranged. In an embodiment, when viewed along the Z-axis direction, the trajectories TR1 and TR2 may have a linear shape, and when viewed along the X-axis or Y-axis direction, the trajectories TR1 and TR2 may have a curved shape. In an embodiment, a designated gap NC may be provided between the first groove 464a and the second groove 464b. The first groove 464a may extend in a direction from the inside of the hinge area HA (or from a position adjacent to the folding axis A) toward the first housing 210, and the second groove 464b may extend in a direction from the inside of the hinge area HA (or a position adjacent to the folding axis A) toward the second housing 220. In an embodiment, the portion adjacent to the folding axis A, e.g., the portion BA1 of FIG. 6, may be deformed between the flat plate shape and the curved shape but, the curvature in the curved shape may be significantly small. For example, the deformation of the BA1 portion may substantially lack a load (e.g., compressive force or tensile force) acting on the signal lines 461a, 461b, and 461c and/or the ground lines 463a, 463b, 463c, and 463d.

According to an embodiment, in an area where the deformation is small as in the portion BA1 although it is a portion of the bending portion, the elastomeric line 465 may be omitted, and at least one via conductor 467 may be disposed in the designated gap NC between the first groove 464a and the second groove 464b. For example, the displacement of the via conductor(s) 467 in the BA1 portion may not substantially affect communication performance. It may be understood that the designated gap NC or at least one via conductor 467 is substantially disposed in the hinge area HA. In an embodiment, the via conductor(s) 467 may be disposed to contact the ground line(s) 463a, 463b, 463c, and 463d through the insulating material layer 469 of the second layer LY2. In an embodiment, it may be understood that the via conductor(s) 467 are embedded (or buried) in the insulating material layer 469 to be disposed to contact the ground line(s) 463a, 463b, 463c, and 463d. In an embodiment, the via conductor(s) 467 may have a trajectory (e.g., the trajectory indicated by 'TR1' and/or 'TR2') in which the first groove 464a and the second groove 464b are aligned.

FIG. 11 is a view illustrating a flexible printed circuit board 506 (e.g., the flexible printed circuit board 266 or 406 of FIGS. 4 to 7) of an electronic device (e.g., the electronic device 101, 200, or 300 of FIGS. 1 to 4 and/or 6) according to an embodiment.

In the embodiment of FIG. 11, unlike in the previous embodiment(s), the elastomeric line(s) 565; 565a, 565b, 565c, and 565d may be disposed between the third layer LY3 and the second layer LY2. Other components shown in FIG. 11 may be similar to those described in previous embodiment(s), for example those described with reference to FIGS. 7 to 10. In the following description, the components easy to understand from the description of the above embodiments are denoted with or without the same reference numerals and their detailed description may be skipped.

Referring to FIG. 11, the elastomeric line(s) 565 may be disposed between the second layer LY2 and the third layer LY3 at a position corresponding to at least one of the ground line(s) 463a, 463b, 463c, and 463d. For example, the elastomeric line(s) 565 may electrically connect the third layer LY3 (e.g., the conductive layer LY3a) to at least one of the ground lines 463a, 463b, 463c, and 463d. For example, the elastomeric line(s) 565 may include an elastomer to which electrically conductive particles are added. In an embodiment, as the elastomeric line(s) 565, the third layer LY3 (e.g., the conductive layer LY3a), and/or the ground line(s) 463a, 463b, 463c, and 463d are combined, an electromagnetic shielding structure may be provided to the signal line(s) 461a, 461b, and 461c and/or a waveguide structure may be implemented. In an embodiment, the position of the neutral plane (e.g., the neutral plane NP of FIG. 9) may be controlled by adjusting the width or thickness of the elastomeric line(s) 565. In an embodiment, in a portion of an area adjacent to the folding axis (e.g., the folding axis A of FIG. 10), a discontinuous section (e.g., the designated gap NC of FIG. 10) in which the elastomeric line 465 is not provided in one trajectory (e.g., the trajectory indicated by "TR1" and/or "TR2" of FIG. 10) may be included. In an embodiment, when there is a discontinuous section of the elastomeric line 565 in a designated trajectory, the flexible printed circuit board 506 may further include at least one via conductor (e.g., the via conductor 467 of FIG. 10) disposed in the discontinuous section.

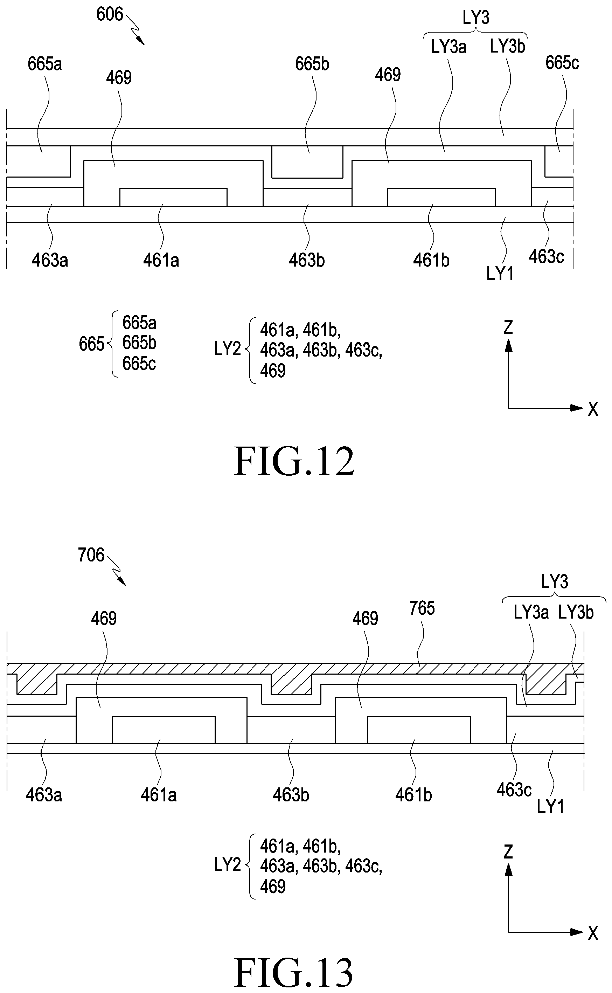

FIG. 12 is a view illustrating a flexible printed circuit board 606 (e.g., the flexible printed circuit board 266 or 406 of FIGS. 4 to 7) of an electronic device (e.g., the electronic device 101, 200, or 300 of FIGS. 1 to 4 and/or 6) according to an embodiment of the disclosure.

In the embodiment of FIG. 12, unlike in the previous embodiment(s), the elastomeric line(s) 665; 665a, 665b, and 665c may be disposed between the insulation layer LY3b and the conductive layer LY3a in the third layer LY3. Other components shown in FIG. 12 may be similar to those described in previous embodiment(s), for example those described with reference to FIGS. 7 to 11. In the following description, the components easy to understand from the description of the above embodiments are denoted with or without the same reference numerals and their detailed description may be skipped.

Referring to FIG. 12, in a position corresponding to at least one of the ground line(s) 463a, 463b, and 463c, the elastomeric line(s) 665 may be disposed between the insulation layer LY3b and the conductive layer LY3a. In an embodiment, the elastomeric line(s) 665 may not include electrically conductive particles and, when implemented as elastomer containing electrically conductive particles, it may be implemented as a portion of the electromagnetic shielding structure together with the conductive layer LY3a.

In an embodiment, the position of the neutral plane (e.g., the neutral plane NP of FIG. 9) may be controlled by adjusting the width or thickness of the elastomeric line(s) 665. In an embodiment, in a portion of an area adjacent to the folding axis (e.g., the folding axis A of FIG. 10), a discontinuous section (e.g., the designated gap NC of FIG. 10) in which the elastomeric line 665 is not provided in one trajectory (e.g., the trajectory indicated by "TR1" and/or "TR2" of FIG. 10) may be included. In an embodiment, when there is a discontinuous section of the elastomeric line 665 in a designated trajectory, the flexible printed circuit board 506 may further include at least one via conductor (e.g., the via conductor 467 of FIG. 10) disposed in the discontinuous section.

FIG. 13 is a view illustrating a flexible printed circuit board 706 (e.g., the flexible printed circuit board 266 or 406 of FIGS. 4 to 7) of an electronic device (e.g., the electronic device 101, 200, or 300 of FIGS. 1 to 4 and/or 6) according to an embodiment.

Unlike in the preceding embodiment(s), the flexible printed circuit board 706 of FIG. 13 may include an elastomeric layer 765 provided on substantially the entire surface of the third layer LY3. In an embodiment, the elastomeric layer 765 may be at least partially received in a groove (e.g., the groove 464(s) of FIG. 9) formed in the third layer LY3, thereby implementing substantially the same elastomeric line as the elastomeric line(s) 465 of FIG. 9.

According to an embodiment of the disclosure, an electronic device (e.g., the electronic device 101, 200, or 300 of FIGS. 1 to 4 and/or FIG. 6) comprises a housing structure including a first housing (e.g., the first housing 210 of FIGS. 2 to 4 and/or FIG. 6) and a second housing (e.g., the second housing 220 of FIGS. 2 to 4 and/or FIG. 6), a hinge structure (e.g., the hinge assembly 202 of FIG. 4) rotatably coupling the first housing and the second housing and configured to provide at least one folding axis (e.g., the folding axis A of FIG. 2, FIG. 7, and/or FIG. 9) serving as a rotational center of the first housing or the second housing, and a flexible printed circuit board (e.g., the flexible printed circuit board 266, 406, or 506 of FIGS. 4 to 11) disposed from an inside of the first housing across the hinge structure (202) to an inside of the second housing. An area of the flexible printed circuit board, passing through the hinge structure, includes a substrate layer (e.g., the first layer LY1 of FIG. 9 and/or FIG. 11), a shielding layer (e.g., the third layer LY3 of FIG. 9 and/or FIG. 11), and a signal line layer (e.g., the second layer LY2 of FIG. 9 and/or FIG. 11) formed between the substrate layer and the shielding layer. The signal line layer includes a signal line (e.g., one of the signal lines 461a, 461b, and 461c of FIG. 9 and/or FIG. 11) and a ground line (e.g., one of the ground lines 463a, 463b, 463c, and 463d of FIG. 9 and/or FIG. 11) that extend along a direction substantially perpendicular to the at least one folding axis and are disposed adjacent to each other. The shielding layer includes a shielding conductive layer (e.g., the conductive layer LY3a of FIG. 9 and/or FIG. 11) spaced apart from the signal line and electrically connected to the ground line and a shielding insulation layer (e.g., the insulation layer LY3b of FIG. 9 and/or FIG. 11) formed on the shielding conductive layer. The flexible printed circuit board includes an elastomeric line layer(s) (e.g., the elastomeric line 465; 465a, 465b, 465c, 465d and/or 565; 565a, 565b, 565c, 565d of FIG. 9 and/or FIG. 11) formed to be at least partially aligned with the ground line in the portion of the flexible printed circuit board passing through an area where the hinge structure is disposed.

The elastomeric line layer is formed on the shielding insulation layer.

The shielding insulation layer includes a recess area (e.g., the groove 464; 464a, 464b of FIGS. 8 to 11) formed at a position corresponding to the ground line, and the elastomeric line layer may be formed in the recess area.

According to an embodiment, an upper surface of the elastomeric line layer may be formed in the recess area to be aligned with an upper surface of the shielding insulation layer on a continuous flat surface or a continuous curved surface.

According to an embodiment, the shielding conductive layer may contact a surface of the ground line.

According to an embodiment, the elastomeric line layer may include a conductive material and electrically connect the shielding conductive layer to the ground line.

According to an embodiment, the signal line layer further may include an insulating material layer at least partially formed between the signal line and the ground line.

According to an embodiment, the electronic device may further comprise at least one groove formed in a surface of the insulation layer at a position corresponding to the ground line. In an embodiment, the at least one groove may include a first groove (e.g., the first groove 464a of FIG. 10) extending from the hinge area toward an inner area of the first housing and a second groove (e.g., the second groove 464b of FIG. 9) extending from the hinge area toward an inner area of the second housing. In an embodiment, the first groove and the second groove may be disposed on one straight trajectory or one curved trajectory with a designated gap therebetween.

According to an embodiment, the signal line layer may include an insulating material layer (e.g., the insulating material layer 469 of FIG. 9 or FIG. 11) provided to surround at least a portion of the signal line or at least a portion of the ground line and at least one via conductor (e.g., the via conductor 467 of FIG. 10) disposed to pass through the insulating material layer in the designated gap between the first groove and the second groove.

According to an embodiment, the designated gap between the first groove and the second groove may be disposed in an area where the hinge structure is disposed.

According to an embodiment, the flexible printed circuit board may be configured so that a portion where the elastomeric line layer is disposed is at least partially deformed as the first housing and the second housing are rotated about the at least one folding axis.

According to an embodiment of the disclosure, an electronic device (e.g., the electronic device 101, 200, or 300 of FIGS. 1 to 4 and/or FIG. 6) may comprise a housing structure including a first housing (e.g., the first housing 210 of FIGS. 2 to 4 and/or FIG. 6) and a second housing (e.g., the second housing 220 of FIGS. 2 to 4 and/or FIG. 6), a hinge structure (e.g., the hinge assembly 202 of FIG. 4) rotatably coupling the first housing and the second housing and configured to provide at least one folding axis (e.g., the folding axis A of FIG. 2, FIG. 7, and/or FIG. 9) serving as a rotational center of the first housing or the second housing, a flexible printed circuit board (e.g., the flexible printed circuit board 266, 406, or 506 of FIGS. 4 to 11) disposed from an inside of the first housing across the area where the hinge structure is disposed to an inside of the second housing, and a processor (e.g., the processor 120 of FIG. 1) or a communication module (e.g., the communication module 190 of FIG. 1) configured to transmit a communication signal using the flexible printed circuit board. In an embodiment, a portion of the flexible printed circuit board, passing through the area where the hinge structure is disposed, may include a substrate layer (e.g., the first layer LY1 of FIG. 9 and/or FIG. 11), a shielding layer (e.g., the third layer LY3 of FIG. 9 and/or FIG. 11), and a signal line layer (e.g., the second layer LY2 of FIG. 9 and/or FIG. 11) formed between the substrate layer and the shielding layer, and the signal line layer may include a signal line (e.g., one of the signal lines 461a, 461b, and 461c of FIG. 9 and/or FIG. 11) and a ground line (e.g., one of the ground lines 463a, 463b, 463c, and 463d of FIG. 9 and/or FIG. 11) that extend along a direction substantially perpendicular to the at least one folding axis and are disposed adjacent to each other. In an embodiment, the shielding layer may include a shielding conductive layer (e.g., the conductive layer LY3a of FIG. 9 and/or FIG. 11) spaced apart from the signal line and electrically connected to the ground line and a shielding insulation layer (e.g., the insulation layer LY3b of FIG. 9 and/or FIG. 11) formed on the shielding conductive layer. In an embodiment, the flexible printed circuit board may include an elastomeric line layer(s) (e.g., the elastomeric line 465; 465a, 465b, 465c, 465d and/or 565; 565a, 565b, 565c, 565d of FIG. 9 and/or FIG. 11) formed to be at least partially aligned with the ground line in the portion of the flexible printed circuit board passing through an area where the hinge structure is disposed.

According to an embodiment, the electronic device may further comprise a circuit board disposed on any one of the first housing and the second housing and a conductive pattern disposed on the other housing of the first housing and the second housing. In an embodiment, the communication module and the conductive pattern may be electrically connected through the signal line to transmit or receive a wireless communication signal.

According to an embodiment, the conductive pattern may constitute a side surface of the other housing of the first housing and the second housing.

According to an embodiment, the electronic device may further comprise a flexible display including a first display area disposed on the first housing, a second display area disposed on the second housing, and a folding area disposed on the hinge structure and a hinge cover disposed between the first housing and the second housing to receive at least a portion of the hinge structure. In an embodiment, at least a portion of the flexible printed circuit board may be fixed to the hinge cover.

In an electronic device (e.g., the electronic device 101, 200, or 300 of FIGS. 1 to 4 and/or FIG. 6) according to an embodiment(s), a flexible printed circuit board (e.g., the flexible printed circuit board 266, 406, or 506 of FIGS. 4 to 11) may connect an electromagnetic shielding layer (e.g., the third layer LY3 of FIG. 9 or 11) to a ground (e.g., the ground line 463a, 463b, 463c, or 463d of FIG. 9 or 11) of a signal line layer (e.g., the second layer LY2 of FIG. 9 or 11), implementing an electromagnetic shielding structure and/or a waveguide structure, thereby increasing stability in communication signal transmission. In an embodiment, the electromagnetic shielding structure implemented by the electromagnetic shielding layer on the flexible printed circuit board may provide a stable communication environment while substantially maintaining the flexibility of the flexible printed circuit board. For example, in a structure in which housings (e.g., the housings 210 and 220 of FIGS. 2 to 4 and/or FIG. 6) are moved or deformed relative to each other, the flexible printed circuit board may be useful in communication signal transmission for mmWave communication.

Effects of the disclosure are not limited to the foregoing, and other unmentioned effects would be apparent to one of ordinary skill in the art from the description of the foregoing embodiment(s).

According to an embodiment of the disclosure, an electronic device (e.g., the electronic device 101, 200, or 300 of Figs. 1 to 4 and/or Fig. 6) may include a first housing (e.g., the first housing 210 of Figs. 2 to 4 and/or Fig. 6), a second housing (e.g., the second housing 220 of Figs. 2 to 4 and/or Fig. 6) configured to rotate about at least one folding axis (e.g., the folding axis A of Fig. 2, Fig. 7, and/or Fig. 9) between a first position facing the first housing and a second position unfolded from the first position by a designated angle, a hinge structure (e.g., the hinge assembly 202 of Fig. 4) disposed in a hinge area (e.g., the hinge area HA of Fig. 5 and/or Fig. 6) between the first housing and the second housing to rotatably couple the first housing and the second housing, and a flexible printed circuit board (e.g., the flexible printed circuit board 266, 406, or 506 of Figs. 4 to 11) disposed from an inside of the first housing across the hinge area to an inside of the second housing. In an embodiment, the flexible printed circuit board may include a first layer (e.g., the first layer LY1 of Fig. 9 and/or Fig. 11), a second layer (e.g., the second layer LY2 of Fig. 9 and/or Fig. 11) disposed on the first layer and including signal lines (e.g., the signal lines 461a, 461b, and 461c of Fig. 9 and/or Fig. 11) and ground lines (e.g., the ground lines 463a, 463b, 463c, and 463d of Fig. 9 and/or Fig. 11) alternately arranged along a direction of the at least one folding axis, a third layer (e.g., the third layer LY3 of Fig. 9 and/or Fig. 11) disposed on the second layer and providing an electromagnetic shielding environment to each of a first signal line and a second signal line adjacent to the first signal line among the signal lines by being electrically connected to at least one of the ground lines, and at least one elastomeric line (e.g., the elastomeric lines 465; 465a, 465b, 465c, 465d and/or 565; 565a, 565b, 565c, 565d of Fig. 9 and/or Fig. 11) disposed corresponding to at least one of the ground lines on the third layer or between the second layer and the third layer.

According to an embodiment, the flexible printed circuit board may further include at least one groove (or recess) (e.g., the groove 464; 464a, 464b of Figs. 8 to 11) formed at a position corresponding to at least one of the ground lines, on a surface of the third layer. In an embodiment, the at least one elastomeric line may include an elastic polymer at least partially filling the at least one groove.

According to an embodiment, the third layer may include an insulation layer (e.g., the insulation layer LY3b of Fig. 9 and/or Fig. 11), an electrically conductive layer (e.g., the conductive layer LY3a of Fig. 9 and/or Fig. 11) disposed between the second layer and the insulation layer and electrically connected to at least one of the grounds, and at least one groove formed at a position corresponding to at least one of the ground lines, in a surface of the insulation layer. In an embodiment, the at least one elastomeric line may include an elastic polymer at least partially filling the at least one groove.

According to an embodiment, the at least one groove may include a first groove (e.g., the first groove 464a of Fig. 10) extending from the hinge area toward an inner area of the first housing and a second groove (e.g., the second groove 464b of Fig. 9) extending from the hinge area toward an inner area of the second housing. In an embodiment, the first groove and the second groove may be disposed on one straight trajectory (e.g., the trajectory indicated by 'TR1' or 'TR2' of Fig. 10) or one curved trajectory with a designated gap therebetween.

According to an embodiment, the second layer may include an insulating material (e.g., the insulating material layer 469 of Fig. 9 or Fig. 11) provided to surround at least a portion of at least one of the signal lines or at least a portion of at least one of the ground lines and at least one via conductor (e.g., the via conductor 467 of Fig. 10) disposed to pass through the insulating material in a designated gap between the first groove and the second groove.

According to an embodiment, the designated gap between the first groove and the second groove may be disposed in the hinge area.

According to an embodiment, the at least one elastomeric line may electrically connect the third layer with at least one of the ground lines by being disposed corresponding to at least one of the ground lines between the second layer and the third layer.

According to an embodiment, the electronic device may further include a flexible display (e.g., the display 230 of Fig. 4) including a first display area (e.g., the first display area 231 of Fig. 4) disposed on the first housing, a second display area (e.g., the second display area 232 of Fig. 4) disposed on the second housing, and a folding area (e.g., the folding area 233 of Fig. 4) disposed corresponding to the hinge area to connect the first display area to the second display area.

According to an embodiment, the elastomeric line may be disposed to at least partially correspond to the hinge area or the folding area.

According to an embodiment, the flexible printed circuit board may be configured so that at least a portion of a portion thereof where the elastomeric line is disposed is deformed as the first housing and the second housing rotate about each other.

According to an embodiment of the disclosure, an electronic device (e.g., the electronic device 101, 200, or 300 of Figs. 1 to 4 and/or Fig. 6) may include a first housing (e.g., the first housing 210 of Figs. 2 to 4 and/or Fig. 6), a second housing (e.g., the second housing 220 of Figs. 2 to 4 and/or Fig. 6) configured to rotate about a folding axis (e.g., the folding axis A of Fig. 2, Fig. 7, and/or Fig. 9), a hinge structure (e.g., the hinge assembly 202 of Fig. 4) disposed in a hinge area (e.g., the hinge area HA of Fig. 5 and/or Fig. 6) between the first housing and the second housing to rotatably couple the first housing and the second housing, a flexible printed circuit board (e.g., the flexible printed circuit board 266, 406, or 506 of Figs. 4 to 11) disposed from an inside of the first housing across the hinge area to an inside of the second housing, and a processor (e.g., the processor 120 of Fig. 1) or a communication module (e.g., the communication module 190 of Fig. 1) configured to transmit a communication signal using the flexible printed circuit board. In an embodiment, the flexible printed circuit board may include a first layer (e.g., the first layer LY1 of Fig. 9 and/or Fig. 11), a second layer (e.g., the second layer LY2 of Fig. 9 and/or Fig. 11) disposed on the first layer and including signal lines (e.g., the signal lines 461a, 461b, and 461c of Fig. 9 and/or Fig. 11) and ground lines (e.g., the ground lines 463a, 463b, 463c, and 463d of Fig. 9 and/or Fig. 11) alternately arranged along a direction of the at least one folding axis, a third layer (e.g., the third layer LY3 of Fig. 9 and/or Fig. 11) disposed on the second layer and providing an electromagnetic shielding environment to each of a first signal line and a second signal line adjacent to the first signal line among the signal lines by being electrically connected to at least one of the ground lines, and at least one elastomeric line (e.g., the elastomeric lines 465; 465a, 465b, 465c, 465d and/or 565; 565a, 565b, 565c, 565d of Fig. 9 and/or Fig. 11) disposed corresponding to at least one of the ground lines on the third layer or between the second layer and the third layer.

According to an embodiment, as at least a portion of the portion where the elastomeric line is disposed is disposed in the hinge area, the flexible printed circuit board may be configured to be deformed as the first housing and the second housing rotate about each other.

According to an embodiment, the flexible printed circuit board may further include at least one groove (or recess) (e.g., the groove 464; 464a, 464b of Figs. 8 to 11) formed at a position corresponding to at least one of the ground lines, on a surface of the third layer. In an embodiment, the at least one elastomeric line may include an elastic polymer at least partially filling the at least one groove.

According to an embodiment, the third layer may include an insulation layer (e.g., the insulation layer LY3b of Fig. 9 and/or Fig. 11), an electrically conductive layer (e.g., the conductive layer LY3a of Fig. 9 and/or Fig. 11) disposed between the second layer and the insulation layer and electrically connected to at least one of the grounds, and at least one groove formed at a position corresponding to at least one of the ground lines, in a surface of the insulation layer. In an embodiment, the at least one elastomeric line may include an elastic polymer at least partially filling the at least one groove.

According to an embodiment, the at least one groove may include a first groove (e.g., the first groove 464a of Fig. 10) extending from the hinge area toward an inner area of the first housing and a second groove (e.g., the second groove 464b of Fig. 9) extending from the hinge area toward an inner area of the second housing. In an embodiment, the first groove and the second groove may be disposed on one straight trajectory (e.g., the trajectory indicated by 'TR1' or 'TR2' of Fig. 10) or one curved trajectory with a designated gap therebetween.

According to an embodiment, the second layer may include an insulating material (e.g., the insulating material layer 469 of Fig. 9 or Fig. 11) provided to surround at least a portion of at least one of the signal lines or at least a portion of at least one of the ground lines and at least one via conductor (e.g., the via conductor 467 of Fig. 10) disposed to pass through the insulating material in a designated gap between the first groove and the second groove.

According to an embodiment, the designated gap between the first groove and the second groove may be disposed in the hinge area.

According to an embodiment, the at least one elastomeric line may electrically connect the third layer with at least one of the ground lines by being disposed corresponding to at least one of the ground lines between the second layer and the third layer.

According to an embodiment, the electronic device may further include a flexible display (e.g., the display 230 of Fig. 4) including a first display area (e.g., the first display area 231 of Fig. 4) disposed on the first housing, a second display area (e.g., the second display area 232 of Fig. 4) disposed on the second housing, and a folding area (e.g., the folding area 233 of Fig. 4) disposed corresponding to the hinge area to connect the first display area to the second display area.

According to an embodiment, the elastomeric line may be disposed to at least partially correspond to the hinge area or the folding area.

While the disclosure has been described and shown in connection with an embodiment thereof, it should be appreciated that an embodiment is intended as limiting the invention but as illustrative. It will be apparent to one of ordinary skill in the art that various changes may be made in form and detail without departing from the overall scope of the appended claims. For example, in the above-described embodiments, a plurality of signal lines and a plurality of ground lines are exemplified as being alternately arranged, but it should be noted that embodiment(s) of the disclosure is not limited thereto. In an embodiment, a structure in which one signal line and one ground line are disposed adjacent to each other may be implemented. In this case, the elastomeric line may be disposed substantially corresponding to the ground line.

## Claims

1. An electronic device (101; 200; 300) comprising:
a housing structure including a first housing (210) and a second housing (220);
a hinge structure (202) rotatably coupling the first housing and the second housing and configured to provide at least one folding axis (A) serving as a rotational center of the first housing or the second housing; and
a flexible printed circuit board (266; 406; 506) disposed from an inside of the first housing across the hinge structure (202) to an inside of the second housing,
wherein an area of the flexible printed circuit board, passing through the hinge structure (202), includes a substrate layer (LY1), a shielding layer (LY3), and a signal line layer (LY2) formed between the substrate layer and the shielding layer,
wherein the signal line layer includes a signal line (461a) and a ground line (463a) that extend along a direction substantially perpendicular to the at least one folding axis and are disposed adjacent to each other,
wherein the shielding layer includes a shielding conductive layer (LY3a) spaced apart from the signal line and electrically connected to the ground line, and a shielding insulation layer (LY3b) formed on the shielding conductive layer,
wherein the flexible printed circuit board includes an elastomeric line layer (465) formed to be at least partially aligned with the ground line in the portion of the flexible printed circuit board passing through an area where the hinge structure is disposed,
wherein the elastomeric line layer is formed on the shielding insulation layer, and
wherein the shielding insulation layer includes a recess area (464) formed at a position corresponding to the ground line, and wherein the elastomeric line layer is formed in the recess area.

2. The electronic device of claim 1, wherein the signal line layer further includes an insulating material layer at least partially formed between the signal line and the ground line.

3. The electronic device of any one of claims 1 to 2, further comprising
at least one groove formed in a surface of the shielding insulation layer at a position corresponding to the ground line,
wherein the at least one groove includes:
a first groove (464a) extending from the hinge area toward an inner area of the first housing; and
a second groove (464b) extending from the hinge area toward an inner area of the second housing, and
wherein the first groove and the second groove are disposed on one straight trajectory (TR1, TR2) or one curved trajectory with a designated gap (NC) therebetween.

4. The electronic device of claim 3, wherein the signal line layer includes:
an insulating material layer (469) provided to surround at least a portion of the signal line or at least a portion of the ground line; and
at least one via conductor (467) disposed to pass through the insulating material layer in the designated gap between the first groove and the second groove.

5. The electronic device of any one of claims 3 or 4, wherein the designated gap between the first groove and the second groove is disposed in an area where the hinge structure is disposed.

6. The electronic device of any one of claims 1 to 5, wherein the flexible printed circuit board is configured so that a portion where the elastomeric line layer is disposed is at least partially deformed as the first housing and the second housing are rotated about the at least one folding axis.

7. The electronic device (101; 200; 300) of any one of claims 1 to 6, further comprising:
a processor or a communication module configured to transmit a communication signal using the flexible printed circuit board;
a circuit board disposed on any one of the first housing and the second housing; and
a conductive pattern disposed on the other housing of the first housing and the second housing,
wherein the communication module is disposed on the circuit board and electrically connected with the conductive pattern through the signal line to transmit or receive a wireless communication signal.

## Patentansprüche

1. Elektronische Vorrichtung (101; 200; 300), die Folgendes umfasst:
eine Gehäusestruktur, die ein erstes Gehäuse (210) und ein zweites Gehäuse (220) enthält;
eine Scharnierstruktur (202), die das erste Gehäuse und das zweite Gehäuse drehbar koppelt und so konfiguriert ist, dass sie mindestens eine Faltachse (A) bereitstellt, die als Drehzentrum des ersten Gehäuses oder des zweiten Gehäuses dient; und
eine flexible Leiterplatte (266; 406; 506), die von einem Inneren des ersten Gehäuses über die Scharnierstruktur (202) zu einem Inneren des zweiten Gehäuses angeordnet ist,
wobei ein Bereich der flexiblen Leiterplatte, der durch die Scharnierstruktur (202) verläuft, eine Substratschicht (LY1), eine Abschirmungsschicht (LY3) und eine zwischen der Substratschicht und der Abschirmungsschicht ausgebildete Signalleitungsschicht (LY2) enthält,
wobei die Signalleitungsschicht eine Signalleitung (461a) und eine Masseleitung (463a) enthält, die sich entlang einer Richtung im Wesentlichen senkrecht zu der mindestens einen Faltachse erstrecken und nebeneinander angeordnet sind,
wobei die Abschirmungsschicht eine leitfähige Abschirmungsschicht (LY3a) enthält, die von der Signalleitung beabstandet und mit der Masseleitung elektrisch verbunden ist, und eine auf der leitfähigen Abschirmungsschicht ausgebildete abschirmende Isolierschicht (LY3b),
wobei die flexible Leiterplatte eine elastomere Leitungsschicht (465) enthält, die so ausgebildet ist, dass sie zumindest teilweise mit der Masseleitung in dem Teil der flexiblen Leiterplatte ausgerichtet ist, der durch einen Bereich verläuft, in dem die Scharnierstruktur angeordnet ist,
wobei die elastomere Leitungsschicht auf der abschirmenden Isolierschicht ausgebildet ist, und
wobei die abschirmende Isolierschicht einen Aussparungsbereich (464) enthält, der an einer Position ausgebildet ist, die der Masseleitung entspricht, und wobei die elastomere Leitungsschicht in dem Aussparungsbereich ausgebildet ist.

2. Elektronische Vorrichtung nach Anspruch 1, wobei die Signalleitungsschicht ferner eine Isolierschicht enthält, die zumindest teilweise zwischen der Signalleitung und der Masseleitung ausgebildet ist.

3. Elektronische Vorrichtung nach einem der Ansprüche 1 bis 2, die ferner Folgendes umfasst:
mindestens eine Nut, die in einer Oberfläche der abschirmenden Isolierschicht an einer Position ausgebildet ist, die der Masseleitung entspricht,
wobei die mindestens eine Nut Folgendes enthält:
eine erste Nut (464A), die sich von dem Scharnierbereich in Richtung eines inneren Bereichs des ersten Gehäuses erstreckt; und
eine zweite Nut (464b), die sich von dem Scharnierbereich in Richtung eines inneren Bereichs des zweiten Gehäuses erstreckt, und
wobei die erste Nut und die zweite Nut auf einer geraden Bahn (TR1, TR2) oder einer gekrümmten Bahn mit einer dazwischenliegenden bestimmten Lücke (NC) angeordnet sind.

4. Elektronische Vorrichtung nach Anspruch 3, wobei die Signalleitungsschicht Folgendes enthält:
eine Isolierschicht (469), die so angeordnet ist, dass sie zumindest einen Teil der Signalleitung oder zumindest einen Teil der Masseleitung umgibt; und
mindestens einen Via-Leiter (467), der so angeordnet ist, dass er durch die Isolierschicht in der bestimmten Lücke zwischen der ersten Nut und der zweiten Nut dringt.

5. Elektronische Vorrichtung nach einem der Ansprüche 3 oder 4, wobei die bestimmte Lücke zwischen der ersten Nut und der zweiten Nut in einem Bereich angeordnet ist, in dem die Scharnierstruktur angeordnet ist.

6. Elektronische Vorrichtung nach einem der Ansprüche 1 bis 5, wobei die flexible Leiterplatte so konfiguriert ist, dass ein Teil, in dem die elastomere Leitungsschicht angeordnet ist, zumindest teilweise verformt wird, wenn das erste Gehäuse und das zweite Gehäuse um die mindestens eine Faltachse gedreht werden.

7. Elektronische Vorrichtung (101; 200; 300) nach einem der Ansprüche 1 bis 6, die ferner Folgendes umfasst:
einen Prozessor oder ein Kommunikationsmodul, das so konfiguriert ist, dass es ein Kommunikationssignal unter Verwendung der flexiblen Leiterplatte überträgt;
eine Leiterplatte, die auf dem ersten Gehäuse oder dem zweiten Gehäuse angeordnet ist; und
ein leitfähiges Muster, das auf dem anderen Gehäuse des ersten Gehäuses und des zweiten Gehäuses angeordnet ist,
wobei das Kommunikationsmodul so auf der Leiterplatte angeordnet und mit dem leitfähigen Muster über die Signalleitung elektrisch verbunden ist, dass es ein drahtloses Kommunikationssignal überträgt oder empfängt.

## Revendications

1. Dispositif électronique (101 ; 200 ; 300) comprenant :
une structure de boîtier incluant un premier boîtier (210) et un deuxième boîtier (220) ;
une structure de charnière (202) couplant de façon rotative le premier boîtier et le deuxième boîtier et configurée pour fournir au moins un axe de pliage (A) servant de centre de rotation du premier boîtier ou du deuxième boîtier ; et
une carte de circuit imprimé flexible (266 ; 406 ; 506) disposée depuis un intérieur du premier boîtier à travers la structure de charnière (202) jusqu'à un intérieur du deuxième boîtier,
où une zone de la carte de circuit imprimé flexible, passant à travers la structure de charnière (202), inclut une couche de substrat (LY1), une couche de blindage (LY3), et une couche de ligne de signal (LY2) formée entre la couche de substrat et la couche de blindage,
où la couche de ligne de signal inclut une ligne de signal (461a) et une ligne de masse (463a) qui s'étendent le long d'une direction sensiblement perpendiculaire à l'au moins un axe de pliage et sont disposées adjacentes l'une à l'autre,
où la couche de blindage inclut une couche conductrice de blindage (LY3a) espacée de la ligne de signal et connectée électriquement à la ligne de masse, et une couche isolante de blindage (LY3b) formée sur la couche conductrice de blindage,
où la carte de circuit imprimé flexible inclut une couche de ligne élastomère (465) formée pour être au moins partiellement alignée avec la ligne de masse dans la partie de carte de circuit imprimé flexible passant à travers une zone où la structure de charnière est disposée,
où la couche de ligne élastomère est formée sur la couche isolante de blindage, et
où la couche isolante de blindage inclut une zone de renfoncement (464) formée à une position correspondant à la ligne de fond, et où la couche de ligne élastomère est formée dans la zone de renfoncement.

2. Dispositif électronique selon la revendication 1, où la couche de ligne de signal inclut en outre une couche de matériau isolant formée au moins partiellement entre la ligne de signal et la ligne de masse.

3. Dispositif électronique selon l'une quelconque des revendications 1 à 2, comprenant en outre
au moins une rainure formée dans une surface de la couche isolante de blindage à une position correspondant à la ligne de masse,
où l'au moins une rainure inclut :
une première rainure (464a) s'étendant depuis la zone de charnière vers une zone intérieure du premier boîtier ; et
une deuxième rainure (464b) s'étendant depuis la zone de charnière vers une zone intérieure du deuxième boîtier, et
où la première rainure et la deuxième rainure sont disposées sur une trajectoire droite (TR1, TR2) ou une trajectoire courbe avec un espace désigné (NC) entre elles.

4. Dispositif électronique selon la revendication 3, où la couche de ligne de signal inclut :
une couche de matériau isolant (469) prévue pour entourer au moins une partie de la ligne de signal ou au moins une partie de la ligne de masse ; et
au moins un via conducteur (467) disposé pour passer à travers la couche de matériau isolant dans l'espace désigné entre la première rainure et la deuxième rainure.

5. Dispositif électronique selon l'une quelconque des revendications 3 ou 4, où l'espace désigné entre la première rainure et la deuxième rainure est disposé dans une zone où la structure de charnière est disposée.

6. Dispositif électronique selon l'une quelconque des revendications 1 à 5, où la carte de circuit imprimé flexible est configurée de sorte qu'une partie où la couche de ligne élastomère est disposée soit au moins partiellement déformée lorsque le premier boîtier et le deuxième boîtier sont tournés autour de l'au moins un axe de pliage.

7. Dispositif électronique (101 ; 200 ; 300) selon l'une quelconque des revendications 1 à 6, comprenant en outre :
un processeur ou un module de communication configuré pour transmettre un signal de communication à l'aide de la carte de circuit imprimé flexible ;
une carte de circuit disposée sur l'un quelconque du premier boîtier et du deuxième boîtier ; et
un motif conducteur disposé sur l'autre boîtier parmi le premier boîtier et le deuxième boîtier,
où le module de communication est disposé sur la carte de circuit et connecté électriquement au motif conducteur par l'intermédiaire de la ligne de signal pour transmettre ou recevoir un signal de communication sans fil.
